# EUROPEAN PATENT APPLICATION

(11) **EP 4 383 008 A1**
(43) Date of publication of application: **12.06.2024**
(21) Application number: 22853302.2
(22) Date of filing: 19.07.2022
(51) Int. Cl.: G03F 7/039, G03F 7/022, G03F 7/023, H10K 50/00

(54) **POSITIVE PHOTOSENSITIVE RESIN COMPOSITION AND DISPLAY DEVICE COMPRISING SAME**

(30) Priority: 04.08.2021 KR 20210102720
(71) Applicant: Dongjin Semichem Co., Ltd., Incheon 22824 (KR)
(72) Inventor: YOUN, Hyoc Min, Hwaseong-si, Gyeonggi-do 18635 (KR); YEO, Tai Hoon, Hwaseong-si, Gyeonggi-do 18635 (KR); KIM, Dong Myung, Hwaseong-si, Gyeonggi-do 18635 (KR); LEE, Sun Hee, Hwaseong-si, Gyeonggi-do 18635 (KR); PARK, Ah Rum, Hwaseong-si, Gyeonggi-do 18635 (KR); JANG, Gun Seok, Hwaseong-si, Gyeonggi-do 18635 (KR); OH, Nu Ri, Hwaseong-si, Gyeonggi-do 18635 (KR); SONG, In Ho, Hwaseong-si, Gyeonggi-do 18635 (KR); LEE, Seok Hyun, Hwaseong-si, Gyeonggi-do 18635 (KR)
(74) Representative: Grünecker Patent- und Rechtsanwälte PartG mbB
(86) International application number: PCT/KR2022/010493
(87) International publication number: WO 2023/013923

(57) **Abstract**

The present disclosure relates to a photosensitive resin composition and a display device comprising same and, more specifically, to: a photosensitive resin composition which, by comprising an alkali-soluble resin comprising at least one structure selected from the group consisting of polyamic acid, polyamic ester, and polyimide, two or more thermal crosslinkable compounds, a photosensitizer, and a solvent, has excellent sensitivity, film residual rate, adhesive force, chemical resistance and heat resistance; and a display device comprising same.

## Description

### [TECHNICAL FIELD]

The present disclosure relates to a positive photosensitive resin composition that enables the formation of an optical member with improved optical properties, and a display device including the same.

### [BACKGROUND ART]

In the recent market, organic light emitting diodes (OLEDs), especially active matrix OLEDs (AMOLEDs), among display devices are in the limelight for various reasons.

Typically, OLED devices include an organic insulating film, and a polyimide photosensitive resin composition is generally used in the formation of the organic insulating film. Among the polyimide precursors used in conventional polyimide photosensitive resin compositions, the technology of substituting polyamic esters with alkyl has been applied, but polyamic esters substituted with alkyl are difficult to control the solubility and have low sensitivity so that improvement measures therefor are desperately needed.

### [DETAILED DESCRIPTION OF INVENTION]

### [TECHNICAL PROBLEMS]

In order to solve the above problems, an object of the present disclosure is to provide a positive photosensitive resin composition with excellent sensitivity, chemical resistance, solar radiation, and driving reliability.

Another object of the present disclosure is to provide a display device including a cured body of the photosensitive resin composition.

### [TECHNICAL SOLUTION]

In order to achieve the above object, a positive photosensitive resin composition according to one aspect of the present disclosure includes: an alkali-soluble resin containing one or more structures selected from the group including polyamic acid, polyamic ester, and polyimide; a first thermally crosslinkable compound containing 1 to 2 functional groups represented by Formula 1 below; a second thermally crosslinkable compound containing 3 to 5 functional groups represented by Formula 1 below; a photosensitizer and a solvent.

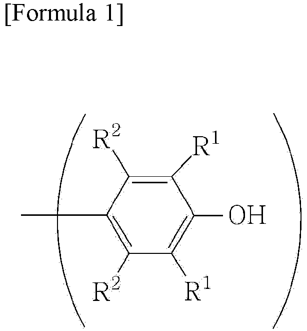

In Formula 1, R¹ are each independently hydrogen, a substituent represented by Formula 2 below, or an organic group having 1 to 30 carbon atoms, at least one of R¹ is a substituent represented by Formula 2 below, and R² are each independently hydrogen, a hydroxy group, or an organic group having 1 to 30 carbon atoms,

In Formula 2 below, m is an integer of 1 to 27, and R³ is an alkyl group having 1 to 3 carbon atoms.

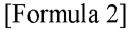

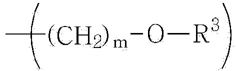

A display device according to another aspect of the present disclosure includes a cured body of the above photosensitive resin composition of the present disclosure.

### [EFFECT OF INVENTION]

The photosensitive resin composition according to one embodiment of the present disclosure is excellent in sensitivity, residual film rate, adhesive force, chemical resistance, and heat resistance, the pattern film containing the positive photosensitive resin composition has an insignificant thickness change rate in a wet environment, and the display device including the photosensitive resin composition has excellent adhesive force, chemical resistance, heat resistance, and solar radiation, and thus has the effect of having the time (T₉₇) of 1,000 hours or more for reducing the luminance by 3% in the driving state. In addition, the photosensitive resin has the effect of enabling productivity improvement due to its excellent sensitivity.

### [BRIEF DESCRIPTION OF THE DRAWING]

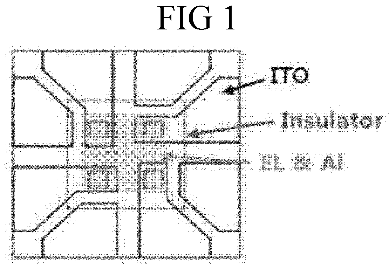

FIG. 1 briefly shows that a pattern film is formed on an indium tin oxide (ITO) substrate on which a pattern is formed according to the embodiment of the present disclosure, and electroluminescent lighting (EL) and aluminum are deposited thereon.

### [MODE FOR INVENTION]

Terms or words used in this specification and claims should not be construed as limited to their common or dictionary meanings, and should be interpreted with meaning and concept consistent with the technical idea of the present disclosure based on the principle that the inventor may appropriately define the concept of terms in order to explain his or her invention in the best way.

Therefore, since the configurations shown in the Examples and Preparation Examples described in this specification are only one of the most preferred embodiments of the present disclosure, and do not represent all of the technical ideas of the present disclosure, it should be understood that there may be various equivalents and variations capable of replacing them at the time of filing the present application.

Hereinafter, embodiments of the present disclosure will be described in detail so that those skilled in the art to which the present disclosure pertains can easily implement it. However, the present disclosure may be implemented in various different forms and is not limited to the Preparation Examples and Examples described herein.

The photosensitive resin composition according to one aspect of the present disclosure is characterized by comprising an alkali-soluble resin, a thermally crosslinkable compound, a photosensitizer, and a solvent.

In particular, the photosensitive resin composition may be a positive photosensitive resin composition that can be used in displays, semiconductor processes, etc.

Specifically, the alkali-soluble resin includes one or more types of polyamic acid, polyamic ester, and polyimide structures, and the alkali-soluble resin may form crosslinks using a thermally crosslinkable compound and a photosensitizer.

The alkali-soluble resin may preferably have a weight average molecular weight of 1,000 to 50,000 g/mol. If the alkali-soluble resin has a weight average molecular weight of less than 1,000 g/mol, there may be problems in that the residual film rate, adhesive force, heat resistance, and solar radiation of the cured body of the photosensitive resin composition are reduced, and if it has a weight average molecular weight exceeding 50,000 g/mol, there may be problems in that when forming a pattern of the cured body, sensitivity to light is not improved, and residues occur in the pattern forming part.

The thermally crosslinkable compound included in the photosensitive resin composition of the present disclosure includes two or more types of thermally crosslinkable compounds having different numbers of functional groups.

Specifically, a thermal crosslinking agent includes a first thermally crosslinkable compound containing 1 to 2 functional groups represented by Formula 1 below, and a second thermally crosslinkable compound containing 3 to 5 functional groups represented by Formula 1.

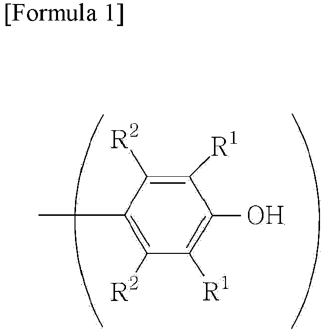

In Formula 1, R¹ are each independently hydrogen, a substituent represented by Formula 2 below, or an organic group having 1 to 30 carbon atoms, at least one of R¹ is a substituent represented by Formula 2 below, and R² are each independently hydrogen, a hydroxy group, or an organic group having 1 to 30 carbon atoms

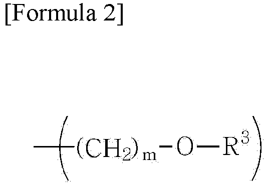

In Formula 2, m is an integer of 1 to 27, and R³ is an alkyl group having 1 to 3 carbon atoms.

In Formula 1, since at least one of R¹ is a substituent represented by Formula 2, it means that 1 to 2 substituents of Formula 2 are substituted in Formula 1. In addition, when m in Formula 2 is 1 to 2, the curing rate of the photosensitive resin composition may be excellent, and particularly when m in Formula 2 is 1 to 2, and R³ is a methyl group, excellent curing rate implementation can be achieved. If the thermally crosslinkable compound contains 90% by mol or more of a methyl group at the R³ position of Formula 2, the curing rate of the photosensitive resin composition may be particularly excellent, and it may be most ideal when it contains 100% by mol of the methyl group.

The thermally crosslinkable compound may include a first thermally crosslinkable compound and a second thermally crosslinkable compound at a weight ratio of 5:95 to 80:20. In the above weight ratio range, the photosensitive resin composition can realize excellent sensitivity and low residual film rate, and at the same time can also realize excellent adhesive force, chemical resistance, heat resistance, solar radiation, and driving reliability.

The solar radiation, hygroscopicity, and driving reliability of the photosensitive resin composition can be greatly improved by controlling the weight ratio of the first thermally crosslinkable compound and the second thermally crosslinkable compound as the thermally crosslinkable compound more precisely. Specifically, the first thermally crosslinkable compound and the second thermally crosslinkable compound as the thermally crosslinkable compound may be contained at a weight ratio of 30:70 to 60:40.

The total thermally crosslinkable compound is preferably contained in an amount of 5 to 50 parts by weight based on 100 parts by weight of the alkali-soluble resin, if the thermally crosslinkable compound is contained in an amount of less than 5 parts by weight, a problem may occur in which the alkali-soluble resin is not sufficiently thermally crosslinked, and if it is contained in an amount exceeding 50 parts by weight, problems of deteriorating hygroscopicity and driving reliability may occur.

The first thermally crosslinkable compound is a compound containing 1 to 2 functional groups represented by Formula 1 above, and may include, for example, one or more of the compounds represented by Formulas 3 to 15 below.

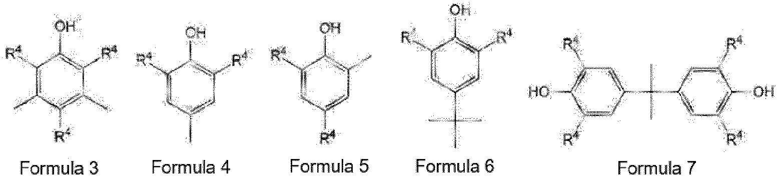

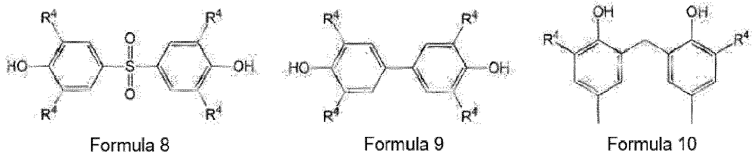

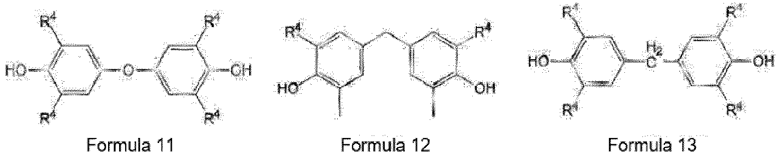

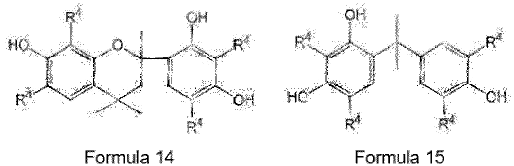

In addition, the second thermally crosslinkable compound is a compound containing 3 to 5 functional groups represented by Formula 1 above, and may include, for example, one or more of the compounds represented by Formulas 16 to 24 below.

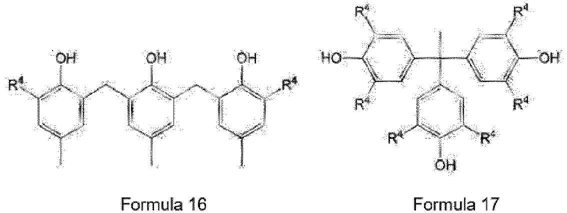

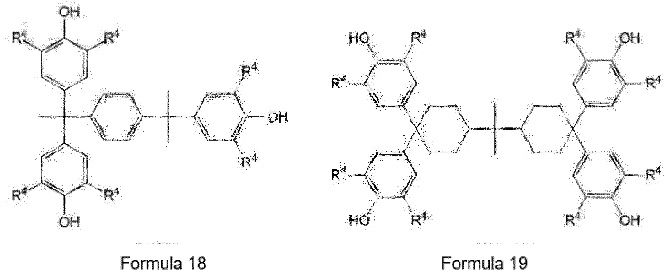

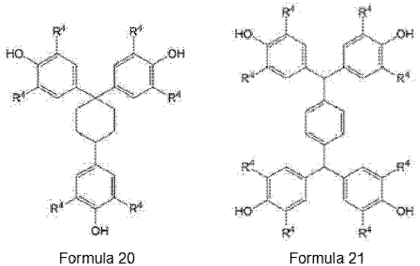

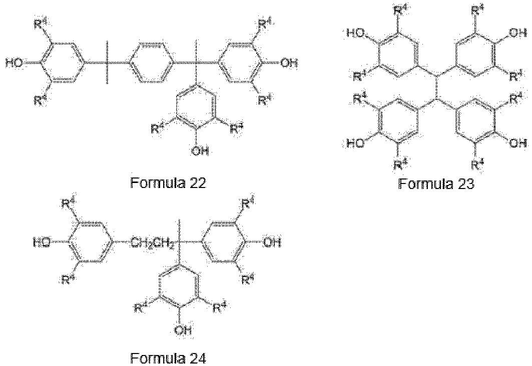

In Formulas 3 to 24, R⁴ are each independently a substituent represented by Formula 2 above, an alkyl group having 2 to 30 carbon atoms, or hydrogen, and at least one of R⁴ in each formula is a substituent represented by Formula 2 above.

The ratio of substituents included in the thermally crosslinkable compound may also affect the crosslinkability of the resin composition. Specifically, it may be preferred that the first thermally crosslinkable compound and the second thermally crosslinkable compound each contain one to two substituents represented by Formula 2 above in the phenolic hydroxy group structure of Formula 1 above in the chemical structure. The substituent of the alkoxy alkyl structure represented by Formula 2 is preferably located at R¹ in the substituent represented by Formula 1 above, but it is all right that the substituent represented by Formula 2 is not necessarily included in Formula 1. In a thermally crosslinkable compound, since the crosslinking reaction is superior when the number of substituents represented by Formula 2 in the structure of Formula 1 having the phenolic hydroxy group is in a range of 1 to 2, there may be an excellent chemical resistance effect.

The alkali-soluble resin of the present disclosure may include one or more of the repeating unit represented by Formula 25 below and the repeating unit represented by Formula 26.

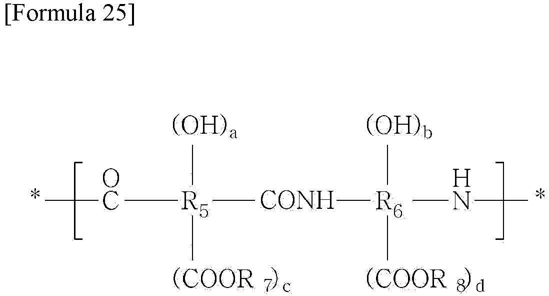

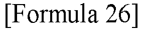

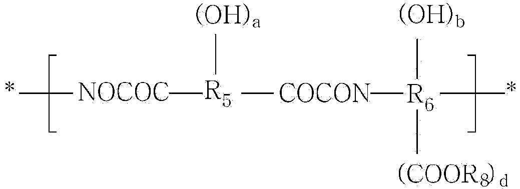

In Formulas 25 and 26, R₅ are each independently a divalent to octavalent organic group having 2 to 200 carbon atoms, R₆ are each independently a divalent to hexavalent organic group having 2 to 200 carbon atoms, R₇ and R₈ are each independently hydrogen or an organic group having 1 to 20 carbon atoms, a and b are each independently 0 to 4, c and d are each independently 0 to 2, a+b is 1 or more, and when a, b, c, or d is O, the relevant substituent is hydrogen.

In Formula 26, NOCOC and COCON are pyrrolidine-2,5-dione, and show an imide structure.

That is, the alkali-soluble resin of the present disclosure may be a polyimide-based resin containing any one or more of the repeating unit represented by Formula 25 above and the repeating unit represented by Formula 26 above as the main chain.

The alkali-soluble resin according to one embodiment of the present disclosure may be a polyimide-based resin that includes the repeating unit represented by Formula 26 above in the main chain more than the repeating unit represented by Formula 25 above. Through this, heat resistance and hygroscopicity are excellent and driving reliability can be further improved, but it is all right that the alkali-soluble resin according to one embodiment of the present disclosure includes only the repeating unit represented by Formula 26. As an example, the alkali-soluble resin included in the photosensitive resin composition of the present disclosure may include the repeating unit represented by Formula 25 above and the repeating unit represented by Formula 26 above at a molar ratio of 0: 100 to 49:51.

The photosensitizer included in the photosensitive resin composition of the present disclosure serves to provide photosensitivity where chemical changes occur in the part irradiated with radiation energy, and the photosensitizer may be preferably contained in an amount of 5 to 50 parts by weight based on 100 parts by weight of the alkali-soluble resin in the photosensitive resin composition. If the photosensitizer is contained in an amount of less than 5 parts by weight based on 100 parts by weight of the alkali-soluble resin, the photosensitivity of the photosensitive resin composition may decrease to cause a problem in that sensitivity on the substrate is reduced, and even if it is contained in an amount exceeding 50 parts by weight, the photosensitivity may be excessively increased to cause a problem in that residues occur in the pattern part.

The photosensitizer may be specifically an esterified quinonediazide compound. For example, a positive photosensitive resin composition in which the part exposed to ultraviolet rays can be removed with an aqueous alkaline solution can be obtained by using a photosensitizer such as naphthoquinonediazide sulfonic acid ester.

The esterified quinonediazide compound as a photosensitizer coexists with an alkali-soluble resin in the solvent, and in order to maintain the characteristics of each component, a phenolic compound may be used as a ballast, and the phenol compound ballast may be represented by, for example, represented by Formulas 27 to 36 below.

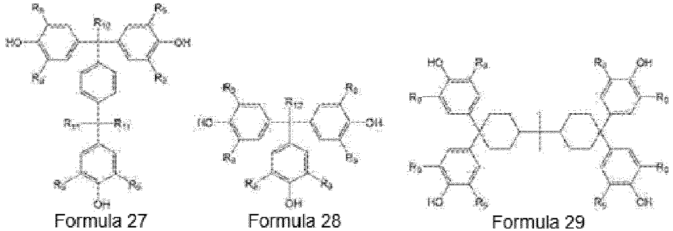

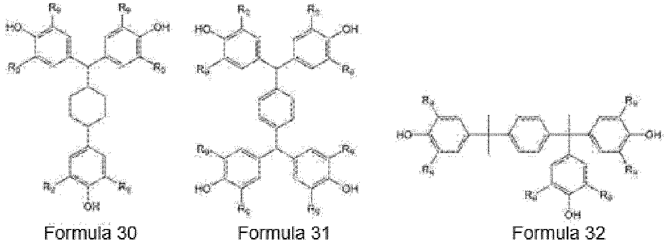

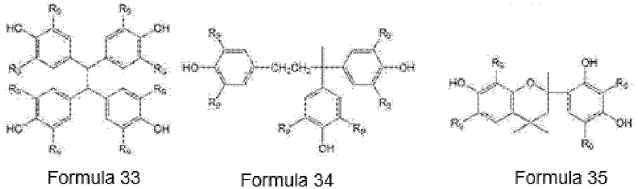

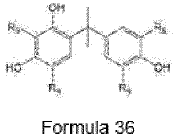

In Formulas 27 to 36, R₉ are each independently one of hydrogen, a halogen atom, a hydroxy group, and an alkyl group having 1 to 4 carbon atoms.

Esterified quinonediazide is characterized in that it is formed by performing an esterification reaction on matrices as shown in Formulas 27 to 36 above, and an unreacted ballast may be included in the photosensitive resin composition, but the smaller the content, the more advantageous it is for improving sensitivity. The content of the unreacted ballast can be measured through high-performance liquid chromatography (HPLC) and through the ratio of the unreacted ballast area to the total solid content area, and the unreacted matrix content can be measured through, for example, HPLC (Alliance E695/X-TERRARP18). An esterified quinonediazide compound with an area ratio of the unreacted ballast to total solid content of less than 10% by area may be preferred, specifically an esterified quinonediazide compound with an area ratio of less than 6% by area may be more preferred, an esterified quinonediazide compound with an area ratio of less than 4% by area may be more preferred, and an esterified quinonediazide compound with an area ratio of less than 1 area% may be most preferred.

The esterified quinonediazide compound may generate impurities such as acids or amines through a process in which the hydroxyl group of the ballast reacts with an acid to form an ester bond and is neutralized again. The impurities generated in the esterification reaction may adversely affect the sensitivity and reliability of the photosensitive resin composition so that it is desirable to remove them as much as possible. However, considering technical difficulties, it is preferred that the impurities are 0.5% by weight or less based on the total solid content, and when the impurities are 0.5% by weight or less, sensitivity and reliability can be particularly excellent. In addition, for the entire photosensitive resin composition solution including the solvent, it may be preferred that the impurities generated in the esterification reaction and neutralization reaction be less than 200 ppm to improve sensitivity and reliability.

The photosensitive resin composition according to one embodiment of the present disclosure may further include an additive as needed. The additive may include, for example, one or more of a thermal acid generator and an ultraviolet absorber, and when the additive is further included, the heat resistance, solar radiation, hygroscopicity, etc. of the photosensitive resin composition may be improved to have the effect capable of securing more excellent panel reliability.

The solvent for the photosensitive resin composition of the present disclosure may include one that is generally used as a solvent for photosensitive resin compositions, for example, one or more selected from the group consisting of gamma-butyrolactone (GBL), N-methylpyrrolidone (NMP), propylene glycol methyl ether acetate (PGMEA), ethyl lactate (EL), methyl-3-methoxypropionate (MMP), propylene glycol monomethyl ether (PGME), diethylene glycol methyl ethyl ether (MEDG), diethylene glycol butyl methyl ether (MBDG), diethylene glycol dimethyl ether (DMDG), diethylene glycol diethyl ether (DEDG), and mixtures thereof, but is not limited to the above examples.

The photosensitive resin composition of the present disclosure may form a cured body. Specifically, after the positive photosensitive resin composition according to one embodiment of the present disclosure may be applied on a support substrate and dried, an exposure process, and a development process using an alkaline developer may be performed, and heat treatment may be performed to form a cured body having a pattern formed thereon, and a cured body having a pattern formed thereon may be formed by performing a general photoresist process.

The cured body of the photosensitive resin composition may be, for example, an insulating film, and specifically may be a surface protective film or an interlayer insulating film of an electronic component for a semiconductor, but is not limited thereto.

Another embodiment of the present disclosure may be a display device including a cured body of the photosensitive resin composition, and a specific example thereof is a display device including an organic electroluminescent element, and may be an organic electroluminescent panel.

According to another embodiment of the present disclosure, an organic electroluminescent panel may provide a display device including: a first electrode formed on a substrate; an insulating layer formed on the first electrode and a second electrode formed on the insulating layer, and the insulating layer may contain a photosensitive resin composition according to one embodiment of the present disclosure.

The insulating layer may be patterned while partially exposing the top surface of the first electrode. In addition, the insulating layer may be formed to cover an edge portion of the first electrode.

Hereinafter, the present disclosure will be described in more detail through Examples, but the present disclosure is not limited to the Examples below.

### [Preparation Example 1: Synthesis of polyimide polymer]

Polyimide polymer synthesis using a polyimide precursor containing polyamic acid and polyamic ester is shown in Synthesis Examples 1 to 16 below.

### (Synthesis Example 1)

After 90 mol of 2,2-bis(3-amino-4-hydroxyphenyl)-hexafluoropropane and 10 mol of 4,4'-oxydianiline as a diamine were dissolved in gamma-butyrolactone under a dry nitrogen stream, 60 mol of 4,4'-oxydiphthalic anhydride (ODPA) as a dianhydride was put therein while stirring the dissolved mixture, the stirred mixture was dissolved, and then stirred at 70°C.

Thereafter, 70 mol of phthalic anhydride (PA) was put therein and stirred at 70°C.

After further stirring at 180°C, the reaction was terminated, and a polyimide polymer with degree of imidization of 55% was obtained.

### (Synthesis Example 2)

A polyimide polymer with degree of imidization of 53% was prepared in the same manner as in Synthesis Example 1 above except that 70 mol of 2,2-bis(3-amino-4-hydroxyphenyl)propane and 30 mol of 4,4'-oxydianiline were used instead of 90 mol of 2,2-bis(3-amino-4-hydroxyphenyl)-hexafluoropropane and 10 mol of 4,4'-oxydianiline as a diamine in Synthesis Example 1 above.

### (Synthesis Example 3)

A polyimide polymer with degree of imidization of 85% was prepared in the same manner as in Synthesis Example 1 above except that 90 mol of 2,2-bis(3-amino-4-hydroxyphenyl)propane and 10 mol of 1,3-bis(4-aminophenoxy)phenyl were used instead of 90 mol of 2,2-bis(3-amino-4-hydroxyphenyl)-hexafluoropropane and 10 mol of 4,4'-oxydianiline as a diamine in Synthesis Example 1 above.

### (Synthesis Example 4)

A polyimide polymer with degree of imidization of 91% was prepared in the same manner as in Synthesis Example 1 above except that 70 mol of 2,2-bis(3-amino-4-hydroxyphenyl)propane and 30 mol of 1,3-bis(4-aminophenoxy)phenyl were used instead of 90 mol of 2,2-bis(3-amino-4-hydroxyphenyl)-hexafluoropropane and 10 mol of 4,4'-oxydianiline as a diamine in Synthesis Example 1 above.

### (Synthesis Example 5)

A polyimide polymer with a degree of imidization of 70% was prepared in the same manner as in Synthesis Example 1 above except that 90 mol of 2,2-bis(3-amino-4-hydroxyphenyl)propane and 10 mol of 4,4'-oxibis[3-(trifluoromethyl)benzenamine were used instead of 90 mol of 2,2-bis(3-amino-4-hydroxyphenyl)-hexafluoropropane and 10 mol of 4,4'-oxydianiline as a diamine in Synthesis Example 1 above.

### (Synthesis Example 6)

A polyimide polymer with a degree of imidization of 75% was prepared in the same manner as in Synthesis Example 1 above except that 70 mol of 2,2-bis(3-amino-4-hydroxyphenyl)propane and 30 mol of 4,4'-oxibis[3-(trifluoromethyl)benzenamine were used instead of 90 mol of 2,2-bis(3-amino-4-hydroxyphenyl)-hexafluoropropane and 10 mol of 4,4'-oxydianiline as a diamine in Synthesis Example 1 above.

### (Synthesis Example 7)

A polyimide polymer with a degree of imidization of 51% was prepared in the same manner as in Synthesis Example 1 above except that 70 mol of 1,4-bis(3,4-dicarboxyphenoxy)benzene dianhydride was used instead of 70 mol of 4,4'-oxydiphthalic anhydride (ODPA) as a dianhydride in Synthesis Example 1 above.

### (Synthesis Example 8)

After 90 mol of 2,2-bis(3-amino-4-hydroxyphenyl)-hexafluoropropane and 10 mol of 4,4'-oxydianiline as a diamine were dissolved in gamma-butyrolactone under a dry nitrogen stream, 70 mol of 4,4'-oxydiphthalic anhydride (ODPA) as a dianhydride was put therein while stirring the dissolved mixture, the stirred mixture was dissolved, and then stirred at 70°C.

Thereafter, 60 mol of phthalic anhydride (PA) was put therein and stirred at 70°C.

30 mol of dimethylformamide dimethyl acetal (DFA) was added to be stirred at 180°C, and then the reaction was terminated to obtain a polyimide polymer with a degree of imidization of 69%.

### (Synthesis Example 9)

A polyimide polymer with a degree of imidization of 88% was prepared in the same manner as in Synthesis Example 8 above except that 70 mol of 2,2-bis(3-amino-4-hydroxyphenyl)propane and 30 mol of 4,4'-oxydianiline were used instead of 90 mol of 2,2-bis(3-amino-4-hydroxyphenyl)-hexafluoropropane and 10 mol of 4,4'-oxydianiline as a diamine in Synthesis Example 8 above.

### (Synthesis Example 10)

A polyimide polymer with a degree of imidization of 85% was prepared in the same manner as in Synthesis Example 8 above except that 90 mol of 2,2-bis(3-amino-4-hydroxyphenyl)propane and 10 mol of 1,3-bis(4-aminophenoxy)phenyl were used instead of 90 mol of 2,2-bis(3-amino-4-hydroxyphenyl)-hexafluoropropane and 10 mol of 4,4'-oxydianiline as a diamine in Synthesis Example 8 above.

### (Synthesis Example 11)

A polyimide polymer with a degree of imidization of 90% was prepared in the same manner as in Synthesis Example 8 above except that 70 mol of 2,2-bis(3-amino-4-hydroxyphenyl)propane and 30 mol of 1,3-bis(4-aminophenoxy)phenyl were used instead of 90 mol of 2,2-bis(3-amino-4-hydroxyphenyl)-hexafluoropropane and 10 mol of 4,4'-oxydianiline as a diamine in Synthesis Example 8 above.

### (Synthesis Example 12)

A polyimide polymer with a degree of imidization of 91% was prepared in the same manner as in Synthesis Example 8 above except that 90 mol of 2,2-bis(3-amino-4-hydroxyphenyl)propane and 10 mol of 4,4'-oxibis[3-(trifluoromethyl)benzenamine were used instead of 90 mol of 2,2-bis(3-amino-4-hydroxyphenyl)-hexafluoropropane and 10 mol of 4,4'-oxydianiline as a diamine in Synthesis Example 8 above.

### (Synthesis Example 13)

A polyimide polymer with a degree of imidization of 75% was prepared in the same manner as in Synthesis Example 8 above except that 70 mol of 2,2-bis(3-amino-4-hydroxyphenyl)propane and 30 mol of 4,4'-oxibis[3-(trifluoromethyl)benzenamine were used instead of 90 mol of 2,2-bis(3-amino-4-hydroxyphenyl)-hexafluoropropane and 10 mol of 4,4'-oxydianiline as a diamine in Synthesis Example 8 above.

### (Synthesis Example 14)

A polyimide polymer with a degree of imidization of 59% was prepared in the same manner as in Synthesis Example 8 above except that 70 mol of 1,4-bis(3,4-dicarboxyphenoxy)benzene dianhydride was used instead of 70 mol of 4,4'-oxydiphthalic anhydride (ODPA) as a dianhydride in Synthesis Example 8 above.

### (Synthesis Example 15)

A polyimide polymer with a degree of imidization of 45% was prepared with the same composition as in Synthesis Example 1 above.

### (Synthesis Example 16)

A polyimide polymer with a degree of imidization of 31% was prepared with the same composition as in Synthesis Example 8 above.

### [Preparation Example 2: Synthesis of esterified quinonediazide compound]

The synthesis of esterified quinonediazide is shown in Synthesis Examples 17 to 19 below.

### (Synthesis Example 17)

1 mol of 4,4'-[1-[4-[1-[4-hydroxyphenyl]-1-methylethyl]phenyl]ethylidene]bisphenol represented by Formula 27-1 below and 2 mol of 5-naphthoquinonediazide sulfonic acid chloride as a ballast were dissolved in 1,4-dioxane at room temperature under a dry nitrogen stream. Triethylamine was dropped thereto so that the temperature did not become 35°C or higher. After dropping, the mixture was stirred at 40°C for 2 hours. A triethylamine salt was filtered and the waste liquid was put into water. Thereafter, the precipitated sediment was filtered and washed in 1% hydrochloric acid water. After that, it was washed three times with water. This sediment was dried with a vacuum dryer to prepare a quinonediazide compound.

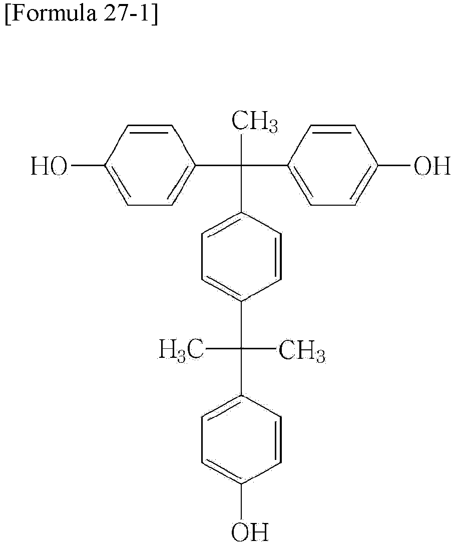

### (Synthesis Example 18)

A quinonediazide compound was prepared in the same manner as in Synthesis Example 15 above except that Formula 29-1 below was used instead of 4,4'-[1-[4-[1-[4-hydroxyphenyl]-1-methylethyl]phenyl]ethylidene]bisphenol as a ballast in Synthesis Example 15 above.

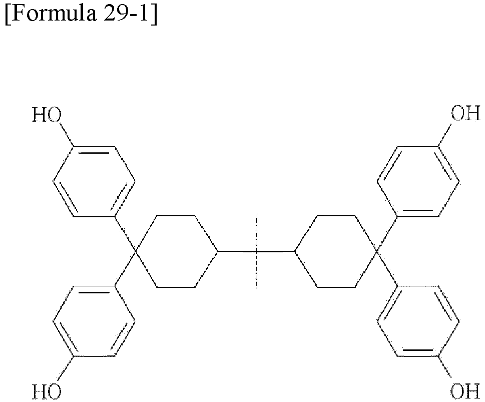

### (Synthesis Example 19)

A quinonediazide compound was prepared in the same manner as in Synthesis Example 15 above except that Formula 28-1 below was used instead of 4,4'-[1-[4-[1-[4-hydroxyphenyl]-1-methylethyl]phenyl]ethylidene]bisphenol as a ballast in Synthesis Example 15 above.

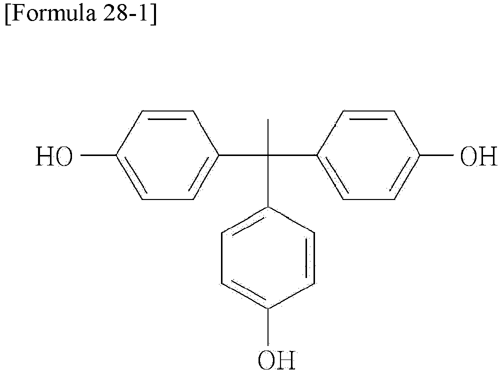

### [Preparation Example 3: Preparation of photosensitive resin composition]

Photosensitive resin compositions were prepared by including the polyimide polymers synthesized in Preparation Example 1 above and the quinonediazide compounds synthesized in Preparation Example 2 above and mixing the compositions of Examples 1 to 51, Reference Examples 1 to 18, and Comparative Examples 1 to 23 according to the composition ratios of Tables 1 to 4 below.

**[Table 1]**

| Evaluation | Polyimide polymer | | | Quinonediazide compound | | Thermal crosslinking agent | | | | |
|---|---|---|---|---|---|---|---|---|---|---|
| | | | | | | First thermally crosslinkable compound (a) | | Second thermally crosslinkable compound (b) | | a/(a+b) |
| Classification | Structure | Content | Degree of imidization | Structure | Content | Structure | Content | Structure | Content | Ratio |
| Example 1 | Synthesis Example 1 | 100 | 55% | Synthesis Example 17 | 40 | A | 1 | D | 20 | 5% |
| Example 2 | Synthesis Example 2 | 100 | 53% | Synthesis Example 18 | 35 | A | 3 | E | 12 | 20% |
| Example 3 | Synthesis Example 3 | 100 | 85% | Synthesis Example 19 | 35 | A | 5 | F | 10 | 33% |
| Example 4 | Synthesis Example 4 | 100 | 91% | Synthesis Example 17 | 25 | A | 5 | D | 15 | 25% |
| Example 5 | Synthesis Example 5 | 100 | 70% | Synthesis Example 18 | 40 | A | 5 | E | 20 | 20% |
| Example 6 | Synthesis Example 6 | 100 | 75% | Synthesis Example 19 | 35 | A | 10 | F | 5 | 67% |
| Example 7 | Synthesis Example 7 | 100 | 51% | Synthesis Example 17 | 35 | A | 10 | D | 10 | 50% |
| Example 8 | Synthesis Example 8 | 100 | 69% | Synthesis Example 18 | 40 | A | 10 | E | 15 | 40% |
| Example 9 | Synthesis Example 9 | 100 | 88% | Synthesis Example 19 | 35 | A | 15 | F | 5 | 75% |
| Example 10 | Synthesis Example 10 | 100 | 85% | Synthesis Example 17 | 35 | A | 15 | D | 10 | 60% |
| Example 11 | Synthesis Example 11 | 100 | 90% | Synthesis Example 18 | 25 | A | 15 | E | 15 | 50% |
| Example 12 | Synthesis Example 12 | 100 | 91% | Synthesis Example 19 | 40 | A | 15 | F | 20 | 43% |
| Example 13 | Synthesis Example 13 | 100 | 75% | Synthesis Example 17 | 30 | A | 20 | D | 5 | 80% |
| Example 14 | Synthesis Example 14 | 100 | 59% | Synthesis Example 18 | 35 | A | 20 | E | 10 | 67% |
| Example 15 | Synthesis Example 1 | 100 | 55% | Synthesis Example 17 | 40 | A | 20 | F | 15 | 57% |
| Example 16 | Synthesis Example 2 | 100 | 53% | Synthesis Example 18 | 35 | A | 20 | D | 20 | 50% |
| Example 17 | Synthesis Example 3 | 100 | 85% | Synthesis Example 19 | 35 | A | 20 | E | 25 | 44% |
| Example 18 | Synthesis Example 4 | 100 | 91% | Synthesis Example 17 | 25 | B | 1 | D | 20 | 5% |
| Example 19 | Synthesis Example 5 | 100 | 70% | Synthesis Example 18 | 40 | B | 3 | E | 12 | 20% |
| Example 20 | Synthesis Example 6 | 100 | 75% | Synthesis Example 19 | 35 | B | 5 | F | 10 | 33% |
| Example 21 | Synthesis Example 7 | 100 | 51% | Synthesis Example 17 | 35 | B | 5 | D | 15 | 25% |
| Example 22 | Synthesis Example 8 | 100 | 69% | Synthesis Example 18 | 40 | B | 5 | E | 20 | 20% |
| Example 23 | Synthesis Example 9 | 100 | 88% | Synthesis Example 19 | 35 | B | 10 | F | 5 | 67% |
| Example 24 | Synthesis Example 10 | 100 | 85% | Synthesis Example 17 | 35 | B | 10 | D | 10 | 50% |
| Example 25 | Synthesis Example 11 | 100 | 90% | Synthesis Example 18 | 25 | B | 10 | E | 15 | 40% |

| | | | | | | | | | | |
|---|---|---|---|---|---|---|---|---|---|---|
| (Content: parts by weight) | | | | | | | | | | |

**[Table 2]**

| Evaluation | Polyimide polymer | | | Quinonediazide compound | | Thermal crosslinking agent | | | | |
|---|---|---|---|---|---|---|---|---|---|---|
| | | | | | | First thermally crosslinkable compound (a) | | Second thermally crosslinkable compound (b) | | a/(a+b) |
| Classification | Structure | Content | Degree of imidization | Structure | Content | Structure | Content | Structure | Content | Ratio |
| Example 26 | Synthesis Example 12 | 100 | 91% | Synthesis Example 19 | 40 | B | 15 | F | 5 | 75% |
| Example 27 | Synthesis Example 13 | 100 | 75% | Synthesis Example 17 | 30 | B | 15 | D | 10 | 60% |
| Example 28 | Synthesis Example 14 | 100 | 59% | Synthesis Example 18 | 35 | B | 15 | E | 15 | 50% |
| Example 29 | Synthesis Example 1 | 100 | 55% | Synthesis Example 17 | 40 | B | 15 | F | 20 | 43% |
| Example 30 | Synthesis Example 2 | 100 | 53% | Synthesis Example 18 | 35 | B | 20 | D | 5 | 80% |
| Example 31 | Synthesis Example 3 | 100 | 85% | Synthesis Example 19 | 35 | B | 20 | E | 10 | 67% |
| Example 32 | Synthesis Example 4 | 100 | 91% | Synthesis Example 17 | 25 | B | 20 | F | 15 | 57% |
| Example 33 | Synthesis Example 5 | 100 | 70% | Synthesis Example 18 | 40 | B | 20 | D | 20 | 50% |
| Example 34 | Synthesis Example 6 | 100 | 75% | Synthesis Example 19 | 35 | B | 20 | E | 25 | 44% |
| Example 35 | Synthesis Example 7 | 100 | 51% | Synthesis Example 17 | 35 | C | 1 | D | 20 | 5% |
| Example 36 | Synthesis Example 8 | 100 | 69% | Synthesis Example 18 | 40 | C | 3 | E | 12 | 20% |
| Example 37 | Synthesis Example 9 | 100 | 88% | Synthesis Example 19 | 35 | C | 5 | F | 10 | 33% |
| Example 38 | Synthesis Example 10 | 100 | 85% | Synthesis Example 17 | 35 | C | 5 | D | 15 | 25% |
| Example 39 | Synthesis Example 11 | 100 | 90% | Synthesis Example 18 | 25 | C | 5 | E | 20 | 20% |
| Example 40 | Synthesis Example 12 | 100 | 91% | Synthesis Example 19 | 40 | C | 10 | F | 5 | 67% |
| Example 41 | Synthesis Example 13 | 100 | 75% | Synthesis Example 17 | 30 | C | 10 | D | 10 | 50% |
| Example 42 | Synthesis Example 14 | 100 | 59% | Synthesis Example 18 | 35 | C | 10 | E | 15 | 40% |
| Example 43 | Synthesis Example 1 | 100 | 55% | Synthesis Example 17 | 40 | C | 15 | F | 5 | 75% |
| Example 44 | Synthesis Example 2 | 100 | 53% | Synthesis Example 18 | 35 | C | 15 | D | 10 | 60% |
| Example 45 | Synthesis Example 3 | 100 | 85% | Synthesis Example 19 | 35 | C | 15 | E | 15 | 50% |
| Example 46 | Synthesis Example 4 | 100 | 91% | Synthesis Example 17 | 25 | C | 15 | F | 20 | 43% |
| Example 47 | Synthesis Example 5 | 100 | 70% | Synthesis Example 18 | 40 | C | 20 | D | 5 | 80% |
| Example 48 | Synthesis Example 6 | 100 | 75% | Synthesis Example 19 | 35 | C | 20 | E | 10 | 67% |
| Example 49 | Synthesis Example 7 | 100 | 51% | Synthesis Example 17 | 35 | C | 20 | F | 15 | 57% |
| Example 50 | Synthesis Example 8 | 100 | 69% | Synthesis Example 18 | 40 | C | 20 | D | 20 | 50% |
| Example 51 | Synthesis Example 9 | 100 | 88% | Synthesis Example 19 | 35 | C | 20 | E | 25 | 44% |

| | | | | | | | | | | |
|---|---|---|---|---|---|---|---|---|---|---|
| (Content: parts by weight) | | | | | | | | | | |

**[Table 3]**

| Evaluation | Polyimide polymer | | | Quinonediazide compound | | Thermal crosslinking agent | | | | |
|---|---|---|---|---|---|---|---|---|---|---|
| | | | | | | First thermally crosslinkable compound (a) | | Second thermally crosslinkable compound (b) | | a/(a+b) |
| Classification | Structure | Content | Degree of imidization | Structure | Content | Structure | Content | Structure | Content | Ratio |
| Reference Example 1 | Synthesis Example 3 | 100 | 85% | Synthesis Example 19 | 35 | G | 5 | F | 10 | 33% |
| Reference Example 2 | Synthesis Example 3 | 100 | 85% | Synthesis Example 19 | 35 | H | 5 | F | 10 | 33% |
| Reference Example 3 | Synthesis Example 6 | 100 | 75% | Synthesis Example 19 | 35 | I | 5 | F | 10 | 33% |
| Reference Example 4 | Synthesis Example 6 | 100 | 75% | Synthesis Example 19 | 35 | J | 5 | F | 10 | 33% |
| Reference Example 5 | Synthesis Example 3 | 100 | 85% | Synthesis Example 19 | 35 | A | 5 | K | 10 | 33% |
| Reference Example 6 | Synthesis Example 1 | 100 | 55% | Synthesis Example 17 | 40 | A | 10 | D | 1 | 91% |
| Reference Example 7 | Synthesis Example 2 | 100 | 53% | Synthesis Example 18 | 35 | B | 20 | E | 1 | 95% |
| Reference Example 8 | Synthesis Example 3 | 100 | 85% | Synthesis Example 19 | 35 | C | 30 | F | 1 | 97% |
| Reference Example 9 | Synthesis Example 8 | 100 | 69% | Synthesis Example 18 | 40 | A | 30 | F | 5 | 86% |
| Reference Example 10 | Synthesis Example 11 | 100 | 90% | Synthesis Example 18 | 25 | B | 30 | F | 5 | 86% |
| Reference Example 11 | Synthesis Example 14 | 100 | 59% | Synthesis Example 18 | 35 | C | 30 | F | 5 | 86% |
| Reference Example 12 | Synthesis Example 1 | 100 | 55% | Synthesis Example 19 | 40 | A | 35 | D | 5 | 88% |
| Reference Example 13 | Synthesis Example 2 | 100 | 53% | Synthesis Example 17 | 30 | B | 35 | F | 3 | 92% |
| Reference Example 14 | Synthesis Example 1 | 100 | 45% | Synthesis Example 17 | 40 | A | 20 | F | 15 | 57% |
| Reference Example 15 | Synthesis Example 1 | 100 | 45% | Synthesis Example 17 | 40 | C | 15 | F | 5 | 75% |
| Reference Example 16 | Synthesis Example 8 | 100 | 31% | Synthesis Example 18 | 40 | C | 20 | D | 20 | 50% |
| Reference Example 17 | Synthesis Example 8 | 100 | 31% | Synthesis Example 18 | 40 | A | 10 | E | 15 | 40% |
| Reference Example 18 | Synthesis Example 1 | 100 | 55% | Synthesis Example 17 | 40 | L | 15 | F | 20 | 43% |

| | | | | | | | | | | |
|---|---|---|---|---|---|---|---|---|---|---|
| (Content: parts by weight) | | | | | | | | | | |

**[Table 4]**

| Evaluation | Polyimide polymer | | | Quinonediazide compound | | Thermal crosslinking agent | | | | |
|---|---|---|---|---|---|---|---|---|---|---|
| | | | | | | First thermally crosslinkable compound (a) | | Second thermally crosslinkable compound (b) | | a/(a+b) |
| Classification | Structure | Content | Degree of imidization | Structure | Content | Structure | Content | Structure | Content | Ratio |
| Comparative Example 1 | Synthesis Example 1 | 100 | 55% | Synthesis Example 17 | 40 | - | - | D | 5 | 0% |
| Comparative Example 2 | Synthesis Example 2 | 100 | 53% | Synthesis Example 18 | 35 | - | - | E | 10 | 0% |
| Comparative Example 3 | Synthesis Example 3 | 100 | 85% | Synthesis Example 19 | 35 | - | - | F | 15 | 0% |
| Comparative Example 4 | Synthesis Example 4 | 100 | 91% | Synthesis Example 17 | 25 | - | - | D | 20 | 0% |
| Comparative Example 5 | Synthesis Example 5 | 100 | 70% | Synthesis Example 18 | 40 | - | - | E | 30 | 0% |
| Comparative Example 6 | Synthesis Example 6 | 100 | 75% | Synthesis Example 19 | 35 | A | 1 | D | 25 | 4% |
| Comparative Example 7 | Synthesis Example 7 | 100 | 51% | Synthesis Example 17 | 35 | A | 0.5 | E | 30 | 2% |
| Comparative Example 8 | Synthesis Example 9 | 100 | 88% | Synthesis Example 19 | 35 | B | 1 | D | 25 | 4% |
| Comparative Example 9 | Synthesis Example 10 | 100 | 85% | Synthesis Example 15 | 35 | B | 0.5 | E | 30 | 2% |
| Comparative Example 10 | Synthesis Example 12 | 100 | 91% | Synthesis Example 17 | 40 | C | 1 | D | 25 | 4% |
| Comparative Example 11 | Synthesis Example 13 | 100 | 75% | Synthesis Example 17 | 30 | C | 0.5 | E | 30 | 2% |
| Comparative Example 12 | Synthesis Example 3 | 100 | 85% | Synthesis Example 18 | 35 | A | 5 | - | - | 100% |
| Comparative Example 13 | Synthesis Example 4 | 100 | 91% | Synthesis Example 19 | 40 | B | 10 | - | - | 100% |
| Comparative Example 14 | Synthesis Example 5 | 100 | 70% | Synthesis Example 17 | 30 | C | 15 | - | - | 100% |
| Comparative Example 15 | Synthesis Example 6 | 100 | 75% | Synthesis Example 18 | 35 | A | 20 | - | - | 100% |
| Comparative Example 16 | Synthesis Example 3 | 100 | 85% | Synthesis Example 19 | 35 | A | 5 | B | 10 | 33% |
| Comparative Example 17 | Synthesis Example 7 | 100 | 51% | Synthesis Example 17 | 35 | A | 10 | C | 10 | 50% |
| Comparative Example 18 | Synthesis Example 8 | 100 | 69% | Synthesis Example 18 | 40 | A | 10 | B | 15 | 40% |
| Comparative Example 19 | Synthesis Example 10 | 100 | 85% | Synthesis Example 17 | 35 | A | 15 | C | 10 | 60% |
| Comparative Example 20 | Synthesis Example 3 | 100 | 85% | Synthesis Example 19 | 35 | E | 5 | F | 10 | 33% |
| Comparative Example 21 | Synthesis Example 7 | 100 | 51% | Synthesis Example 17 | 35 | F | 10 | D | 10 | 50% |
| Comparative Example 22 | Synthesis Example 8 | 100 | 69% | Synthesis Example 18 | 40 | D | 10 | E | 15 | 40% |
| Comparative Example 23 | Synthesis Example 10 | 100 | 85% | Synthesis Example 17 | 35 | K | 15 | D | 10 | 60% |

| | | | | | | | | | | |
|---|---|---|---|---|---|---|---|---|---|---|
| (Content: parts by weight) | | | | | | | | | | |

The thermal crosslinking agent structures applied in Tables 1 to 4 above are as follows.

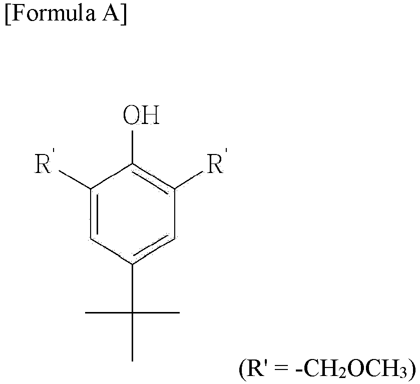

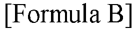

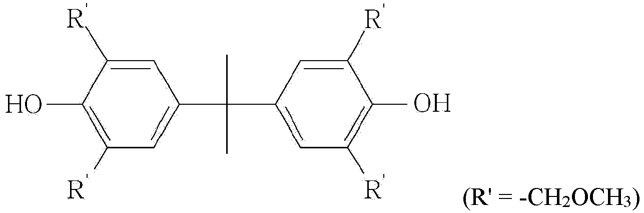

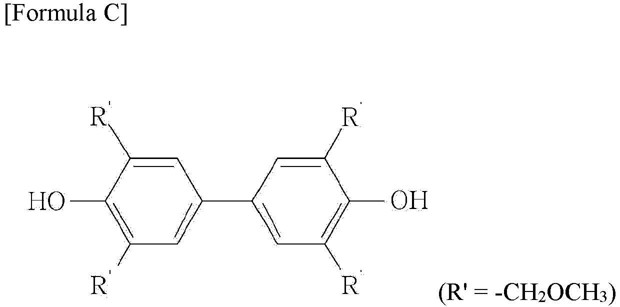

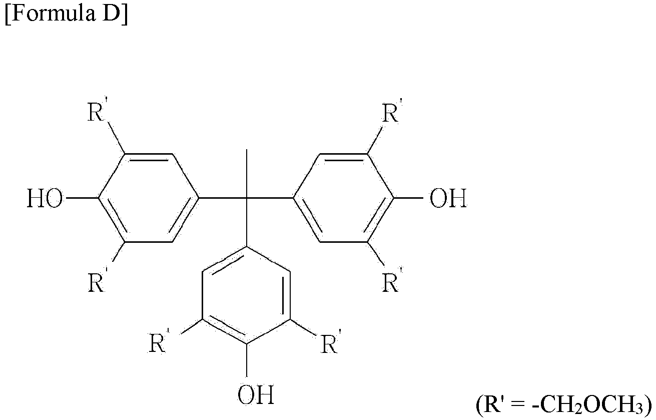

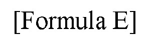

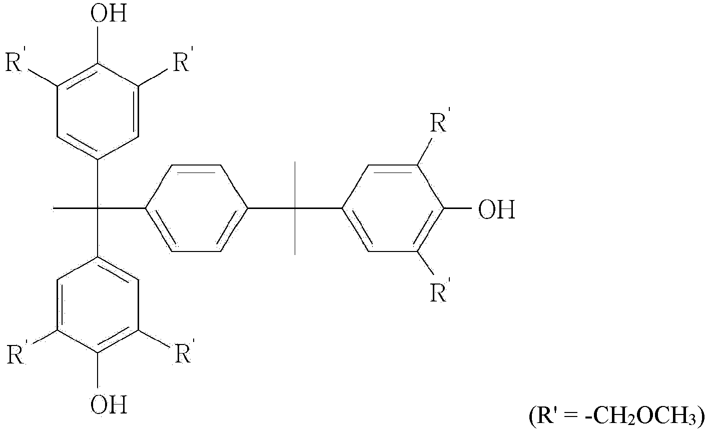

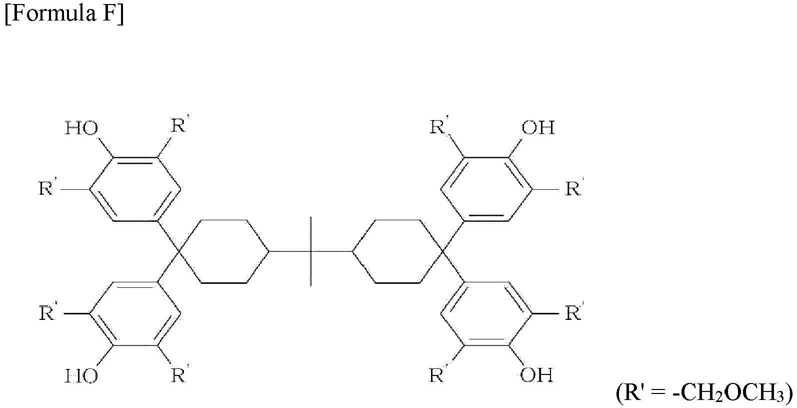

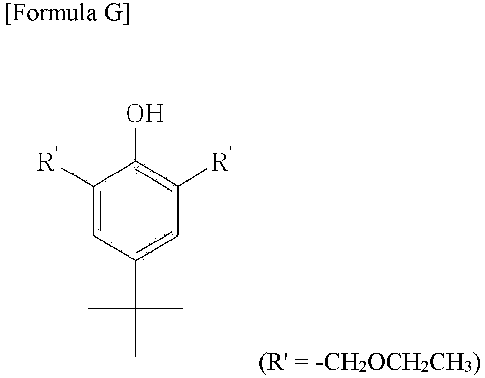

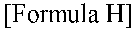

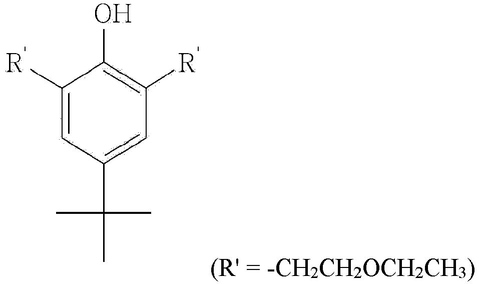

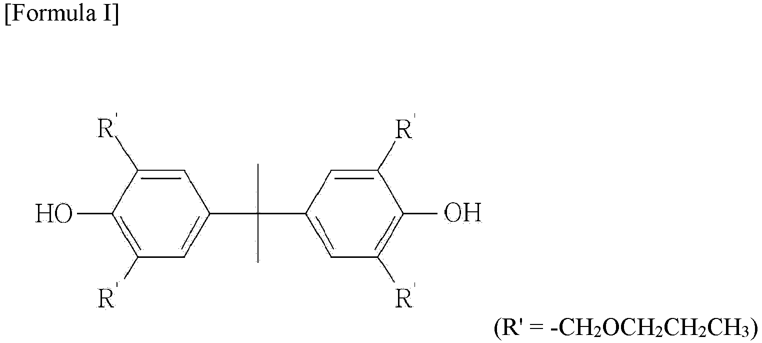

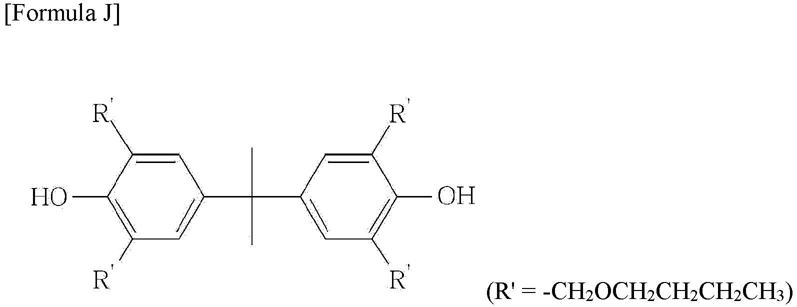

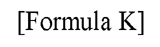

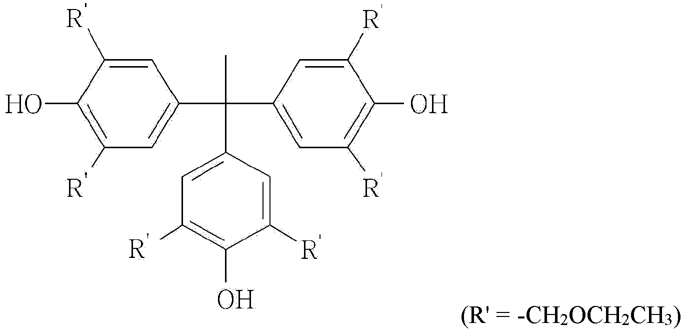

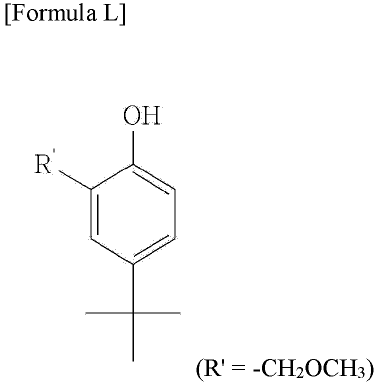

### [Experimental Example: Evaluation of physical properties of photosensitive resin compositions]

Sensitivity, residual film rate, adhesive force, chemical resistance, heat resistance, solar radiation, hygroscopicity, and driving reliability for Examples 1 to 51, Reference Examples 1 to 18, and Comparative Examples 1 to 23 prepared according to Preparation Example 3 above were measured in accordance with the following standards and are shown in Tables 5 to 8 below.

After the photosensitive resin compositions of Examples 1 to 51, Reference Examples 1 to 18, and Comparative Examples 1 to 23 above were each applied onto a glass substrate using a slit coater, a vacuum drying (VCD) process was performed on the photosensitive resin compositions applied onto the glass substrate to a pressure of 40 Pa, and the vacuum-dried photosensitive resin compositions were prebaked on a hot plate at 120°C for 2 minutes to form a film with a thickness of 3.0 µm.

### 1) Sensitivity

After irradiating the film formed as described above with a dose amount of ultraviolet rays with an intensity of 20 mW/cm² in broadband using a predetermined pattern mask based on a contact hole CD with a sensitivity of 2.5 µm, it was developed with an aqueous solution containing 2.38% by weight of tetramethyl ammonium hydroxide at 23°C for 1 minute, and then washed with ultrapure water for 1 minute. Then, it was cured in an oven at 250°C for 60 minutes to obtain a patterned film with a thickness of 2.0 µm.

Cases where the sensitivity is 80 mJ or less are marked as ⊚, cases where the sensitivity is between more than 80 mJ and not more than 120 mJ are marked as ○, and cases where the sensitivity is more than 120 mJ are marked as X.

### 2) Residual film rate

The thickness changes in films formed during the sensitivity measurement in 1) above were measured.

Residual film rate is represented by Thickness after curing / Thickness after prebaking, and when the residual film rate is 60% or more, it is indicated as ○, when it is not less than 50% to less than 60%, it is indicated as △, and when it is less than 50%, it is indicated as X.

### 3) Adhesive force

Pattern films were formed in the same manner as during the sensitivity measurement in 1) above, but the adhesive forces were compared and evaluated based on the minimum CD of the attached dot pattern.

Cases where adhesive force is secured when the minimum CD of the dot pattern is 5 µm or more are indicated as ○, cases where adhesive force is secured when the minimum CD of the dot pattern is 10 µm or more are indicated as △, and cases where adhesive force is secured or not secured when the minimum CD of the dot pattern is 15 µm or more are indicated as X.

### 4) Chemical resistance

The manufactured substrate was immersed in methylpyrrolidone (NMP) for 60°C/120 seconds, a rate of change in cured film thickness before and after immersion was measured, and cases where the rate of change in cured film thickness is less than 150 Å are indicated as ⊚, cases where the rate of change in cured film thickness is not less than 150 Å to less than 300 Å are indicated as ○, cases where the rate of change in cured film thickness is not less than 300 Å to less than 600 Å are indicated as Δ, and cases where the rate of change in cured film thickness is not less than 600Å are indicated as X.

### 5) Heat resistance

Heat resistance was measured using TGA. After sampling the pattern films formed during the sensitivity measurement in 1) above, the temperature was raised at a rate of 10°C per minute from room temperature to 900°C using TGA.

Cases where the 5% by weight loss temperature is more than 300°C are indicated as ○, cases where the 5% by weight loss temperature is 280 to 300°C are indicated as Δ, and cases where the 5% by weight loss temperature is less than 280°C are indicated as X.

### 6) Solar radiation resistance

Pattern films are formed on the ITO substrate patterned in the same manner as during the sensitivity measurement in 1) above, and EL is deposited. Al is deposited on the top as a cathode electrode, and the encapsulation process is performed. After irradiating an exposure dose of 2,100 J 10 times using the Xenon Lamp Solar Simulator, the time (T₉₇) for 3% luminance drop in the on state was evaluated. Cases where 1,000 hours or more are secured are marked as ⊚, cases where not less than 800 hours to less than 1,000 hours are secured are marked as ○, and cases where less than 800 hours are secured are marked as X.

### 7) Hygroscopicity

The pattern films formed during the sensitivity measurement in 1) above were purified in a constant temperature, constant humidity oven based on 85°C and 85% RH for 240 hours, and then the hygroscopicity was evaluated based on the change in film thickness before and after putting them into the oven.

Cases where the thickness change rate is less than 100 Å are indicated as ⊚, cases where the thickness change rate is not less than 100 Å to less than 300 Å are indicated as ○, cases where the thickness change rate is not less than 300 Å to less than 600 Å are indicated as △, and cases where the thickness change rate is 600 Å or more are indicated as X.

### 8) Driving reliability

Referring to FIG. 1, pattern films are formed on the ITO substrate patterned in the same manner as during the sensitivity measurement in 1) above, and EL is deposited. Al is deposited on the top as a cathode electrode, and the encapsulation process is performed.

The time (T₉₇) for 3% luminance drop with the device turned on was evaluated based on 85°C and 85% RH. Cases where more than 1,000 hours or more are secured are marked as ⊚, cases where not less than 800 hours to less than 1,000 hours are secured are marked as ○, cases where 600 to 800 hours are secured are marked as △, and cases where less than 600 hours are secured are marked as X.

**[Table 5]**

| Evaluation | A) | B) | C) | D) | E) | F) | G) | H) |
|---|---|---|---|---|---|---|---|---|
| Classification | Sensitivity | Residual film rate | Adhesive force | Chemical resistance | Heat resistance | Solar radiation resistance | Hygroscopicity | Driving reliability |
| Example 1 | ○ | ○ | ○ | ○ | ○ | ○ | ○ | ○ |
| Example 2 | ○ | ○ | ○ | ○ | ○ | ○ | ○ | ○ |
| Example 3 | ○ | ○ | ○ | ○ | ○ | ⊚ | ⊚ | ⊚ |
| Example 4 | ○ | ○ | ○ | ○ | ○ | ○ | ○ | ○ |
| Example 5 | ○ | ○ | ○ | ○ | ○ | ○ | ○ | ○ |
| Example 6 | ○ | ○ | ○ | ○ | ○ | ○ | ○ | ○ |
| Example 7 | ○ | ○ | ○ | ○ | ○ | ⊚ | ⊚ | ⊚ |
| Example 8 | ○ | ○ | ○ | ○ | ○ | ⊚ | ⊚ | ⊚ |
| Example 9 | ○ | ○ | ○ | ○ | ○ | ○ | ○ | ○ |
| Example 10 | ○ | ○ | ○ | ○ | ○ | ⊚ | ⊚ | ⊚ |
| Example 11 | ○ | ○ | ○ | ○ | ○ | ⊚ | ⊚ | ⊚ |
| Example 12 | ○ | ○ | ○ | ○ | ○ | ⊚ | ⊚ | ⊚ |
| Example 13 | ○ | ○ | ○ | ○ | ○ | ○ | ○ | ○ |
| Example 14 | ○ | ○ | ○ | ○ | ○ | ○ | ○ | ○ |
| Example 15 | ○ | ○ | ○ | ○ | ○ | ⊚ | ⊚ | ⊚ |
| Example 16 | ○ | ○ | ○ | ○ | ○ | ⊚ | ⊚ | ⊚ |
| Example 17 | ○ | ○ | ○ | ○ | ○ | ⊚ | ⊚ | ⊚ |
| Example 18 | ○ | ○ | ○ | ○ | ○ | ○ | ○ | ○ |
| Example 19 | ○ | ○ | ○ | ○ | ○ | ○ | ○ | ○ |
| Example 20 | ○ | ○ | ○ | ○ | ○ | ⊚ | ⊚ | ⊚ |
| Example 21 | ○ | ○ | ○ | ○ | ○ | ○ | ○ | ○ |
| Example 22 | ○ | ○ | ○ | ○ | ○ | ○ | ○ | ○ |
| Example 23 | ○ | ○ | ○ | ○ | ○ | ○ | ○ | ○ |
| Example 24 | ○ | ○ | ○ | ○ | ○ | ⊚ | ⊚ | ⊚ |
| Example 25 | ○ | ○ | ○ | ○ | ○ | ⊚ | ⊚ | ⊚ |

**[Table 6]**

| Evaluation | A) | B) | C) | D) | E) | F) | G) | H) |
|---|---|---|---|---|---|---|---|---|
| Classification | Sensitivity | Residual film rate | Adhesive force | Chemical resistance | Heat resistance | Solar radiation resistance | Hygroscopicity | Driving reliability |
| Example 26 | ○ | ○ | ○ | ○ | ○ | ○ | ○ | ○ |
| Example 27 | ○ | ○ | ○ | ○ | ○ | ⊚ | ⊚ | ⊚ |
| Example 28 | ○ | ○ | ○ | ○ | ○ | ⊚ | ⊚ | ⊚ |
| Example 29 | ○ | ○ | ○ | ○ | ○ | ○ | ○ | ○ |
| Example 30 | ○ | ○ | ○ | ○ | ○ | ○ | ○ | ○ |
| Example 31 | ○ | ○ | ○ | ○ | ○ | ○ | ○ | ○ |
| Example 32 | ○ | ○ | ○ | ○ | ○ | ⊚ | ⊚ | ⊚ |
| Example 33 | ○ | ○ | ○ | ○ | ○ | ⊚ | ⊚ | ⊚ |
| Example 34 | ○ | ○ | ○ | ○ | ○ | ⊚ | ⊚ | ⊚ |
| Example 35 | ○ | ○ | ○ | ○ | ○ | ○ | ○ | ○ |
| Example 36 | ○ | ○ | ○ | ○ | ○ | ○ | ○ | ○ |
| Example 37 | ○ | ○ | ○ | ○ | ○ | ⊚ | ⊚ | ⊚ |
| Example 38 | ○ | ○ | ○ | ○ | ○ | ○ | ○ | ○ |
| Example 39 | ○ | ○ | ○ | ○ | ○ | ○ | ○ | ○ |
| Example 40 | ○ | ○ | ○ | ○ | ○ | ○ | ○ | ○ |
| Example 41 | ○ | ○ | ○ | ○ | ○ | ⊚ | ⊚ | ⊚ |
| Example 42 | ○ | ○ | ○ | ○ | ○ | ⊚ | ⊚ | ⊚ |
| Example 43 | ○ | ○ | ○ | ○ | ○ | ○ | ○ | ○ |
| Example 44 | ○ | ○ | ○ | ○ | ○ | ⊚ | ⊚ | ⊚ |
| Example 45 | ○ | ○ | ○ | ○ | ○ | ⊚ | ⊚ | ⊚ |
| Example 46 | ○ | ○ | ○ | ○ | ○ | ⊚ | ⊚ | ⊚ |
| Example 47 | ○ | ○ | ○ | ○ | ○ | ○ | ○ | ○ |
| Example 48 | ○ | ○ | ○ | ○ | ○ | ○ | ○ | ○ |
| Example 49 | ○ | ○ | ○ | ○ | ○ | ⊚ | ⊚ | ⊚ |
| Example 50 | ○ | ○ | ○ | ○ | ○ | ⊚ | ⊚ | ⊚ |
| Example 51 | ○ | ○ | ○ | ○ | ○ | ⊚ | ⊚ | ⊚ |

**[Table 7]**

| Evaluation | A) | B) | C) | D) | E) | F) | G) | H) |
|---|---|---|---|---|---|---|---|---|
| Classification | Sensitivity | Residual film rate | Adhesive force | Chemical resistance | Heat resistance | Solar radiation resistance | Hygroscopicity | Driving reliability |
| Reference Example 1 | ○ | ○ | ○ | Δ | ○ | ○ | ○ | ○ |
| Reference Example 2 | ○ | ○ | ○ | Δ | ○ | ○ | ○ | ○ |
| Reference Example 3 | ○ | ○ | ○ | Δ | o | o | ○ | ○ |
| Reference Example 4 | ○ | ○ | ○ | Δ | o | o | ○ | ○ |
| Reference Example 5 | ○ | ○ | ○ | Δ | ○ | ○ | ○ | ○ |
| Reference Example 6 | ○ | ○ | ○ | Δ | ○ | ○ | ○ | ○ |
| Reference Example 7 | ○ | ○ | ○ | Δ | ○ | ○ | ○ | ○ |
| Reference Example 8 | ○ | ○ | ○ | Δ | ○ | ○ | ○ | ○ |
| Reference Example 9 | ○ | ○ | ○ | Δ | ○ | ○ | ○ | ○ |
| Reference Example 10 | ○ | ○ | ○ | Δ | ○ | ○ | ○ | ○ |
| Reference Example 11 | ○ | ○ | ○ | Δ | ○ | ○ | ○ | ○ |
| Reference Example 12 | ○ | ○ | ○ | Δ | ○ | ○ | ○ | ○ |
| Reference Example 13 | ○ | ○ | ○ | Δ | ○ | ○ | ○ | ○ |
| Reference Example 14 | ○ | ○ | ○ | ○ | ○ | ○ | ○ | Δ |
| Reference Example 15 | ○ | ○ | ○ | ○ | ○ | ○ | ○ | Δ |
| Reference Example 16 | ○ | ○ | ○ | ○ | ○ | ○ | ○ | Δ |
| Reference Example 17 | ○ | ○ | ○ | ○ | ○ | ○ | ○ | Δ |
| Reference Example 18 | ○ | ○ | Δ | Δ | ○ | ○ | ○ | ○ |

**[Table 8]**

| Evaluation | A) | B) | C) | D) | E) | F) | G) | H) |
|---|---|---|---|---|---|---|---|---|
| Classification | Sensitivity | Residual film rate | Adhesive force | Chemical resistance | Heat resistance | Solar radiation resistance | Hygroscopicity | Driving reliability |
| Comparative Example 1 | ○ | ○ | X | X | X | X | ○ | X |
| Comparative Example 2 | ○ | ○ | X | X | X | X | ○ | X |
| Comparative Example 3 | ○ | ○ | X | X | X | X | ○ | X |
| Comparative Example 4 | ○ | ○ | X | X | X | X | ○ | X |
| Comparative Example 5 | ○ | ○ | X | X | X | X | ○ | X |
| Comparative Example 6 | ○ | ○ | X | X | X | X | ○ | X |
| Comparative Example 7 | ○ | ○ | X | X | X | X | ○ | X |
| Comparative Example 8 | ○ | ○ | X | X | X | X | ○ | X |
| Comparative Example 9 | ○ | ○ | X | X | X | X | ○ | X |
| Comparative Example 10 | ○ | ○ | X | X | X | X | ○ | X |
| Comparative Example 11 | ○ | ○ | X | X | X | X | ○ | X |
| Comparative Example 12 | ○ | ○ | X | X | X | X | ○ | X |
| Comparative Example 13 | ○ | ○ | X | X | X | X | ○ | X |
| Comparative Example 14 | ○ | ○ | X | X | X | X | ○ | X |
| Comparative Example 15 | ○ | ○ | X | X | X | X | ○ | X |
| Comparative Example 16 | ○ | ○ | ○ | X | X | X | ○ | X |
| Comparative Example 17 | ○ | ○ | ○ | X | X | X | ○ | X |
| Comparative Example 18 | ○ | ○ | ○ | X | X | X | ○ | X |
| Comparative Example 19 | ○ | ○ | ○ | X | X | X | ○ | X |
| Comparative Example 20 | X | ○ | ○ | X | X | X | ○ | X |
| Comparative Example 21 | X | ○ | ○ | X | X | X | ○ | X |
| Comparative Example 22 | X | ○ | ○ | X | X | X | ○ | X |
| Comparative Example 23 | X | ○ | ○ | X | X | X | ○ | X |

Although the preferred embodiments of the present disclosure have been described in detail above, the scope of rights of the present disclosure is not limited thereto, and various modifications and improved forms of those skilled in the art using the basic concept of the present disclosure defined in the following claims also fall within the scope of the rights of the present disclosure.

## Claims

1. A positive photosensitive resin composition comprising:
an alkali-soluble resin containing one or more structures selected from the group including polyamic acid, polyamic ester, and polyimide;
a first thermally crosslinkable compound containing 1 to 2 functional groups represented by the following Formula 1;
a second thermally crosslinkable compound containing 3 to 5 functional groups represented by the following Formula 1;
a photosensitizer; and
a solvent;: 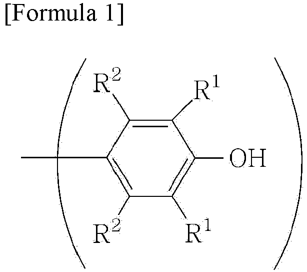
In the Formula 1, R¹ are each independently hydrogen, a substituent represented by the following Formula 2, or an organic group having 1 to 30 carbon atoms, at least one of R¹ is a substituent represented by the following Formula 2, and R² are each independently hydrogen, a hydroxy group, or an organic group having 1 to 30 carbon atoms, and
In the following Formula 2, m is an integer of 1 to 27, and R³ is an alkyl group having 1 to 3 carbon atoms:

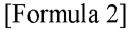

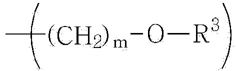

2. The positive photosensitive resin composition of claim 1, wherein m in the Formula 2 is 1 to 2.

3. The positive photosensitive resin composition of claim 1, wherein the first thermally crosslinkable compound and the second thermally crosslinkable compound have a weight ratio of 5:95 to 80:20.

4. The positive photosensitive resin composition of claim 1, wherein the first thermally crosslinkable compound and the second thermally crosslinkable compound have a weight ratio of 30:70 to 60:40.

5. The positive photosensitive resin composition of claim 1, wherein a total thermally crosslinkable compound is contained in an amount of 5 to 50 parts by weight based on 100 parts by weight of the alkali-soluble resin.

6. The positive photosensitive resin composition of claim 1, wherein the first thermally crosslinkable compound includes one or more of the compounds represented by the following Formulas 3 to 15, and
the second thermally crosslinkable compound includes one or more of the compounds represented by the following Formulas 16 to 24: 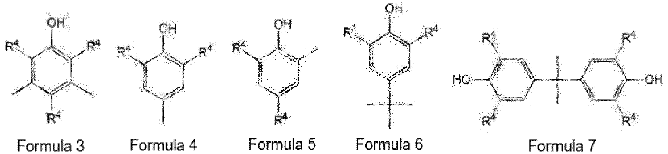 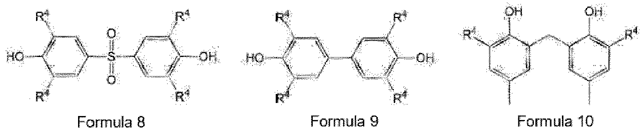 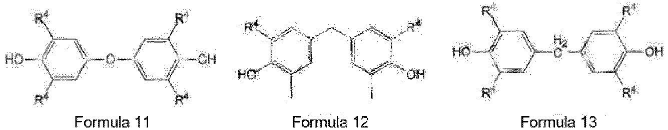 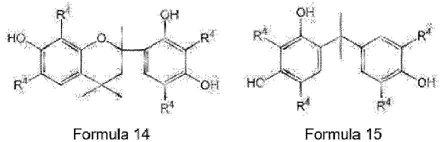 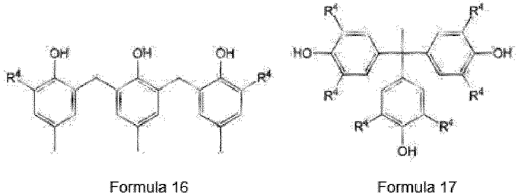 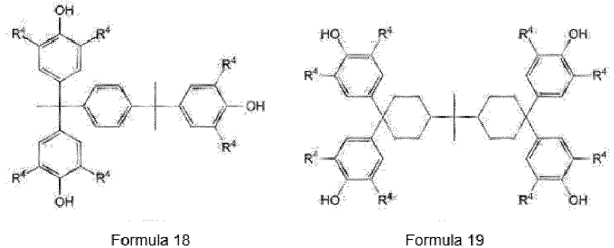 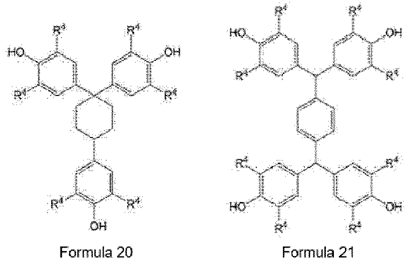 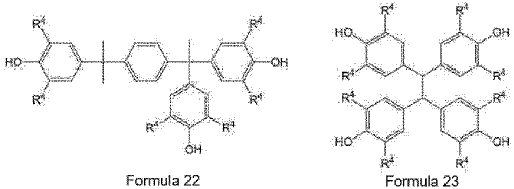 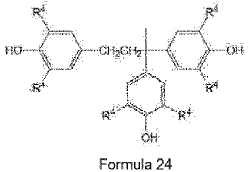
In Formulas 3 to 24, R⁴ are each independently a substituent represented by Formula 2 above, an alkyl group having 2 to 30 carbon atoms, or hydrogen, and at least one of R⁴ in each formula is a substituent represented by Formula 2 above.

7. The positive photosensitive resin composition of claim 1, wherein the first thermally crosslinkable compound and the second thermally crosslinkable compound each contain one to two substituents represented by Formula 2 above in the phenolic hydroxy group structure of Formula 1 above in the chemical structure.

8. The positive photosensitive resin composition of claim 1, wherein the alkali-soluble resin includes one or more of the repeating unit represented by the following Formula 25 and the repeating unit represented by the following Formula 26: 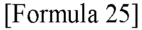 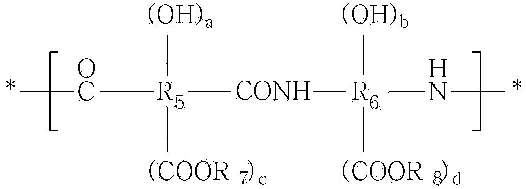 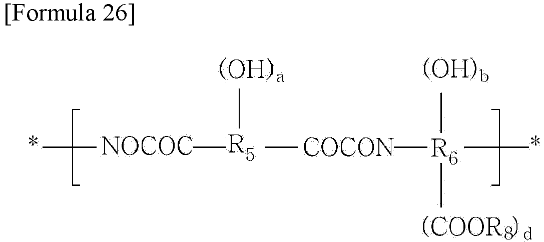 In Formulas 25 and 26, R₅ are each independently a divalent to octavalent organic group having 2 to 200 carbon atoms, R₆ are each independently a divalent to hexavalent organic group having 2 to 200 carbon atoms, R₇ and R₈ are each independently hydrogen or an organic group having 1 to 20 carbon atoms, a and b are each independently 0 to 4, c and d are each independently 0 to 2, a+b is 1 or more, and when a, b, c, or d is O, the relevant substituent is hydrogen.

9. The positive photosensitive resin composition of claim 8, wherein the alkali-soluble resin includes the repeating unit represented by Formula 25 above and the repeating unit represented by Formula 26 above at a molar ratio of 0: 100 to 49:51.

10. The positive photosensitive resin composition of claim 1, wherein the photosensitizer is contained in an amount of 5 to 50 parts by weight based on 100 parts by weight of the alkali-soluble resin.

11. The positive photosensitive resin composition of claim 1, wherein the photosensitizer is an esterified quinonediazide compound.

12. The positive photosensitive resin composition of claim 11, wherein the esterified quinonediazide compound uses one or more phenolic compounds among the following Formulas 27 to 36 as a ballast: 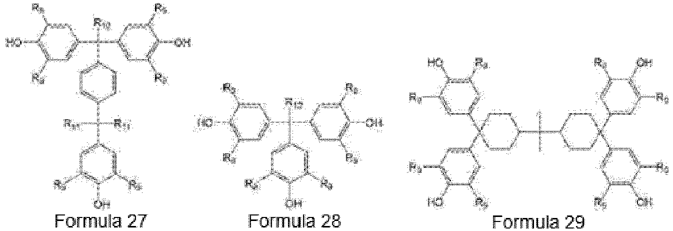 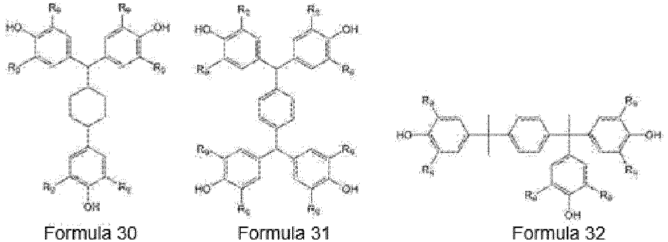 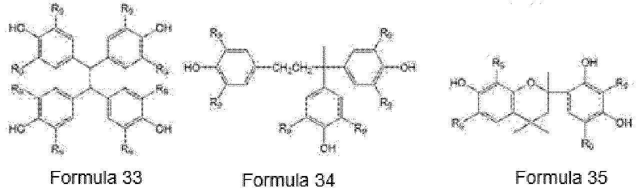 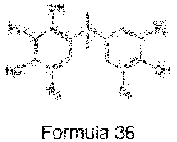 In Formulas 27 to 36, R₉ are each independently one of hydrogen, a halogen atom, a hydroxy group, and an alkyl group having 1 to 4 carbon atoms.

13. The positive photosensitive resin composition of claim 1, further comprising one or more additives of a thermal acid generator and an ultraviolet absorber.

14. A display device comprising a cured body of the photosensitive resin composition of any one of claim 1 to 13.

15. The display device of claim 14, wherein the display device is an organic electroluminescent panel.
